# EUROPÄISCHE PATENTANMELDUNG

(11) **EP 2 645 831 A1**
(43) Veröffentlichungstag der Anmeldung: **02.10.2013**
(21) Anmeldenummer: 12162376.3
(22) Anmeldetag: 30.03.2012
(51) Int. Cl.: H05K 5/00

(54) **Gehäuse für ein elektrisches Gerät, Verfahren zur Herstellung eines solchen Gehäuses, elektrisches Gerät mit einem solchen Gehäuse und Verwendung eines solchen Gehäuses für ein elektrisches Gerät**

(71) Anmelder: Siemens Aktiengesellschaft, 80333 München (DE)
(72) Erfinder: Hoffmann, Ingolf, 91074 Herzogenaurach (DE)

(57) **Zusammenfassung**

Gehäuse für ein elektrisches Gerät, Verfahren zur Herstellung eines solchen Gehäuses, elektrisches Gerät mit einem solchen Gehäuse und Verwendung eines solchen Gehäuses für ein elektrisches Gerät

Die Erfindung betrifft ein Gehäuse für ein elektrisches Gerät, ein Verfahren zur Herstellung eines solchen Gehäuses, ein elektrisches Gerät mit einem solchen Gehäuse und eine Verwendung eines solchen Gehäuses für ein elektrisches Gerät, wobei bei dem Gehäuse mindestens eine Oberfläche zur Verringerung des Diffusionskoeffizienten metallisiert ist.

## Beschreibung

Gehäuse für ein elektrisches Gerät, Verfahren zur Herstellung eines solchen Gehäuses, elektrisches Gerät mit einem solchen Gehäuse und Verwendung eines solchen Gehäuses für ein elektrisches Gerät

Die vorliegende Erfindung betrifft ein Gehäuse für ein elektrisches Gerät, insbesondere ein Automatisierungsgerät wie weiter unten definiert. Die Erfindung betrifft im Weiteren auch ein Verfahren zur Herstellung eines solchen Gehäuses sowie ein elektrisches Gerät, insbesondere ein Automatisierungsgerät, mit einem solchen Gehäuse und schließlich eine Verwendung eines solchen Gehäuses für ein elektrisches Gerät, insbesondere ein Automatisierungsgerät.

Gehäuse oder Gehäuseteile für elektrische Geräte der eingangs genannten Art sind häufig aus einem Kunststoff gefertigt. In der Industrie verbreitete Kunststoffe besitzen allerdings einen geringen Diffusionswiderstand. Ionen wie OH⁻ oder H⁺, aber auch Moleküle wie H₂O können durch den Kunststoff diffundieren, wenn eine Konzentrationsdifferenz zwischen innerem Volumen und der Umgebung vorliegt.

Die Struktur der gebräuchlichen Kunststoffe ist nicht in der Lage, eine Diffusion von Ionen oder kleinen Moleküle zu verhindern. So ist bei jedem Kunststoff die Aufnahme solcher Ionen oder Moleküle leicht bestimmbar, denn sie ist so groß, dass sie mit einer Massenzunahme einhergeht und eine Volumenzunahme bewirkt. Für die gebräuchlichen Kunststoffe findet man dazu in der Literatur entsprechende Angaben.

Wenn Ionen oder Moleküle, im Folgenden zusammenfassend als Teilchen bezeichnet, in den jeweiligen Kunststoff diffundieren können, so wird es nach dem zweiten Fick'schen Gesetz bei Anwesenheit eines Konzentrationsunterschieds zur Diffusion in das Innere des aus dem jeweiligen Kunststoff gebildeten Gehäuses oder Behälters kommen. Dadurch wird ein Konzentrationsunterschied ausgeglichen.

Dieser Vorgang wird als Selbstdiffusion bezeichnet und ist bei einigen Bauteilen, wie sie bei elektrischen Geräten der eingangs genannten Art häufig Verwendung finden, zum Beispiel Folienkondensatoren, besonders störend. Die Folien solcher Folienkondensatoren sind nämlich selbst ebenfalls in der Lage, Feuchtigkeit aufzunehmen. Wenn in das Gehäuse des elektrischen Gerätes aufgrund eines Konzentrationsunterschieds und resultierender Selbstdiffusion Feuchtigkeit eindringt, kommt es auch zu einer Feuchtigkeitsaufnahme durch solche Bauteile. Bei einer Feuchtigkeitsaufnahme ändern sich allerdings deren technische Eigenschaften, zum Beispiel die Eigenschaften von Folienkondensatoren. Dies kann auch den bei Folienkondensatoren erwünschten Selbstheilungseffekt beeinträchtigen.

Eine Aufgabe der vorliegenden Erfindung besteht folglich darin, eine Möglichkeit anzugeben, Gehäuse für elektrische Geräte der eingangs genannten Art so anzupassen, dass eine Selbstdiffusion verhindert oder zumindest reduziert ist.

Diese Aufgabe wird erfindungsgemäß mit einem Gehäuse für ein elektrisches Gerät, insbesondere ein Automatisierungsgerät, mit den Merkmalen des Anspruchs 1 gelöst. Dazu ist bei einem derartigen Gehäuse vorgesehen, dass das Gehäuse auf einer Außen- oder Innenoberfläche metallisiert ist.

Der Begriff Automatisierungsgerät umfasst sämtliche Geräte, Einrichtungen oder Systeme, also neben zum Beispiel Steuerungen wie speicherprogrammierbaren Steuerungen, Prozessrechnern, (Industrie-)Computern und dergleichen auch Antriebssteuerungen, Frequenzumrichter und Ähnliches, wie sie zur Steuerung, Regelung und/oder Überwachung technologischer Prozesse zum Beispiel zum Umformen oder Transportieren von Material, Energie oder Information etc. eingesetzt werden oder einsetzbar sind, wobei insbesondere über geeignete technische Einrichtungen, wie z.B. Sensoren oder Aktoren, Energie aufgewandt oder gewandelt wird.

Durch die Metallisierung entsteht auf der Außen- oder Innenoberfläche des Gehäuses eine metallische Schicht. Bereits Schichtdicken von wenigen Mikrometern (µm) sind hinreichend, um einen Diffusionskoeffizienten des metallisierten Kunststoffs so weit zu erhöhen, dass die Selbstdiffusion verhindert oder auf sehr geringe Werte reduziert wird.

Der Begriff Gehäuse wie hier und nachfolgend verwendet meint Gehäuseteile, Gehäuseschalen, Gehäusedeckel und so weiter, also sämtliche Teile und Geometrien, die, gegebenenfalls kombiniert mit anderen gleichartigen Teilen, zur Aufnahme eines elektrischen Gerätes geeignet sind.

Vorteilhafte Ausgestaltungen der Erfindung sind Gegenstand der Unteransprüche. Dabei verwendete Rückbeziehungen weisen auf die weitere Ausbildung des Gegenstandes des Hauptanspruches durch die Merkmale des jeweiligen Unteranspruches hin. Sie sind nicht als ein Verzicht auf die Erzielung eines selbständigen, gegenständlichen Schutzes für die Merkmalskombinationen der rückbezogenen Unteransprüche zu verstehen. Des Weiteren ist im Hinblick auf eine Auslegung der Ansprüche bei einer näheren Konkretisierung eines Merkmals in einem nachgeordneten Anspruch davon auszugehen, dass eine derartige Beschränkung in den jeweils vorangehenden Ansprüchen nicht vorhanden ist.

Bei einer Ausführungsform des Gehäuses ist vorgesehen, dass sowohl die Außenoberfläche wie auch die Innenoberfläche metallisiert ist. Dies verhindert sowohl Diffusion von außen in das Innere des Gehäuses wie auch Diffusion vom Inneren des Gehäuses in den Kunststoff, aus dem das Gehäuse gebildet ist.

Bei einem Verfahren zur Herstellung eines derartigen Gehäuses ist vorgesehen, dass ein Gehäusegrundkörper auf einer Außen-oder Innenoberfläche metallisiert wird. Der Gehäusegrundkörper ist dabei aus einem Kunststoff gefertigt und weist eine gegebenenfalls auch dreidimensional strukturierte Außen- und Innenoberfläche auf. Der Gehäusegrundkörper wird auf der Außen- oder Innenoberfläche zur Verringerung des Diffusionskoeffizienten, nämlich zur Verringerung des Diffusionskoeffizienten der Kombination aus der durch die Metallisierung aufgebrachten Schicht und dem Material des Gehäusegrundkörpers, metallisiert.

Bei einer Ausführungsform des Verfahrens ist vorgesehen, dass der Gehäusegrundkörper auf einer Außen- und Innenoberfläche metallisiert wird. Dies verhindert - wie oben beschrieben - die Diffusion in das Innere des Gehäuses, aber auch Diffusion vom Inneren des Gehäuses in den Kunststoff des Gehäusegrundkörpers.

Bei einer weiteren Ausführungsform des Verfahrens ist vorgesehen, dass das Metallisieren berührungslos erfolgt. Berührungsloses Metallisieren ist im Vergleich zum ansonsten auch zum Beispiel durch Tauchen oder dergleichen möglichen Metallisieren besonders gleichmäßig und kann in einem definierten Prozess erfolgen, der üblicherweise vollautomatisch abläuft und damit keine Benutzerhandlungen erfordert, so dass Bedienpersonal nicht mit den zum Metallisieren verwendeten Elementen in Kontakt kommt, die eventuell heiß und/oder gesundheitsgefährdend sein können.

Zum Metallisieren einer Außen- oder Innenoberfläche des Gehäusegrundkörpers kommt speziell ein Verfahren der sogenannten physikalischen Gasphasenabscheidung (Physical Vapour Deposition - PVD) in Betracht. Dieses Verfahren sorgt für eine besonders gleichmäßige Metallisierung der Außen- oder Innenoberfläche des Gehäusegrundkörpers.

Insgesamt betrifft die Erfindung damit auch ein elektrisches Gerät, insbesondere ein Automatisierungsgerät wie oben definiert, mit einem Gehäuse wie hier und nachfolgend beschrieben oder mit einem nach einem Verfahren wie hier und nachfolgend beschrieben hergestellten Gehäuse. Schließlich betrifft die Erfindung auch die Verwendung eines Gehäuses wie hier und nachfolgend beschrieben oder die Verwendung eines nach einem Verfahren wie hier und nachfolgend beschrieben hergestellten Gehäuses als Gehäuse mit einem verminderten Diffusionskoeffizienten für ein elektrisches Gerät, insbesondere ein Automatisierungsgerät.

Nachfolgend wird ein Ausführungsbeispiel der Erfindung anhand der Zeichnung näher erläutert. Einander entsprechende Gegenstände oder Elemente sind in allen Figuren mit den gleichen Bezugszeichen versehen.

Es zeigen
- FIG 1: einen Gehäusegrundkörper zur Verwendung als Gehäuse oder Gehäuseteil eines elektrischen Geräts mit einer metallisierten Innenoberfläche und
- FIG 2: einen Gehäusegrundkörper zur Verwendung als Gehäuse oder Gehäuseteil eines elektrischen Geräts mit einer metallisierten Außenoberfläche.

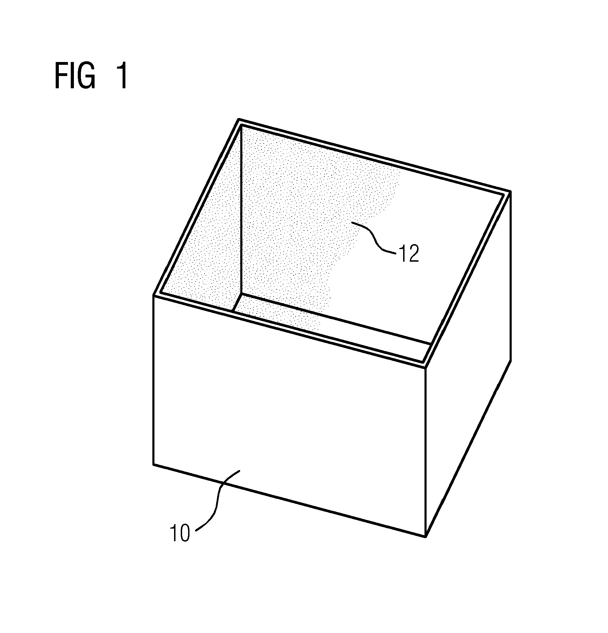

FIG 1 zeigt schematisch vereinfacht einen Gehäusegrundkörper 10 für ein Gehäuse eines selbst nicht dargestellten elektrischen Gerätes. Eine Innenoberfläche des Gehäusegrundkörpers 10 ist metallisiert, indem auf dieser Innenoberfläche eine metallische Schicht 12 aufgebracht ist. Zur Veranschaulichung der Metallisierung ist diese Schicht 12 in der Darstellung auf der Innenoberfläche nur abschnittsweise gezeigt. Tatsächlich ist vorgesehen, dass bei einem metallisierten Gehäusegrundkörper 10 dessen komplette Innenoberfläche mit einer solchen Schicht 12 versehen ist.

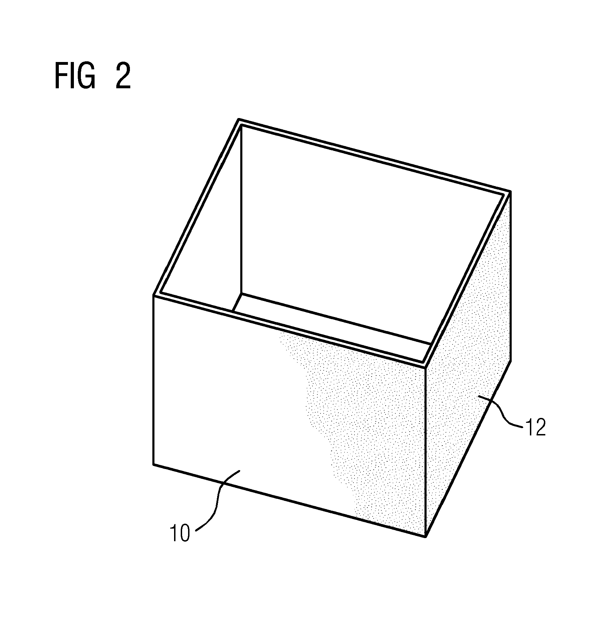

FIG 2 zeigt schematisch vereinfacht einen Gehäusegrundkörper 10 für ein Gehäuse eines selbst nicht dargestellten elektrischen Gerätes. Eine Außenoberfläche des Gehäusegrundkörpers 10 ist metallisiert, indem auf dieser Außenoberfläche eine metallische Schicht 12 aufgebracht ist. Zur Veranschaulichung der Metallisierung ist diese Schicht 12 in der Darstellung auf der Außenoberfläche nur abschnittsweise gezeigt. Tatsächlich ist vorgesehen, dass bei einem metallisierten Gehäusegrundkörper 10 dessen komplette Außenoberfläche mit einer solchen Schicht 12 versehen ist.

Die Darstellungen in FIG 1 und FIG 2 zeigen nur sehr einfache Gehäusegeometrien und entsprechende Gehäusegrundkörper 10. Selbstverständlich können die Gehäusegeometrien beliebig komplex sein und es ist, speziell wenn das Metallisieren mit einer physikalischen Gasphasenabscheidung erfolgt, in keinster Weise erforderlich, dass der Gehäusegrundkörper 10 mehrheitlich ebene Flächenabschnitte umfasst. Stattdessen können bei einer solchen Gasphasenabscheidung beliebig strukturierte Oberflächen metallisiert werden.

Darüber hinaus gilt es zu bemerken, dass in FIG 1 und FIG 2 aus Gründen der einfachen Darstellung nur offene Gehäusegrundkörper 10 gezeigt sind. Selbstverständlich ist zur Kapselung eines elektrischen Gerätes in einem metallisierten Gehäuse ein allseitig geschlossenes Gehäuse vorgesehen. Ein solches allseitig geschlossenes Gehäuse kann durch zum Beispiel zwei der in FIG 1 oder FIG 2 gezeigten Gehäusegrundkörper 10 erhalten werden. Ansonsten kommt bei den in FIG 1 und FIG 2 dargestellten Geometrien auch die Verwendung eines nicht dargestellten metallisierten Deckels in Betracht. Grundsätzlich gilt, dass die Geometrie der jeweiligen Gehäusegrundkörper 10 für die Verwendbarkeit des Ansatzes gemäß der Erfindung ohne Belang ist, so dass die schematisch vereinfachten Darstellungen in FIG 1 und FIG 2 ausdrücklich nur als beispielhaft zu verstehen sind.

Obwohl die Erfindung im Detail durch das Ausführungsbeispiel näher illustriert und beschrieben wurde, so ist die Erfindung nicht durch das oder die offenbarten Beispiele eingeschränkt und andere Variationen können vom Fachmann hieraus abgeleitet werden, ohne den Schutzumfang der Erfindung zu verlassen. Einzelne im Vordergrund stehende Aspekte der hier eingereichten Beschreibung lassen sich damit kurz wie folgt zusammenfassen:
Angegeben werden ein Gehäuse für ein elektrisches Gerät, ein Verfahren zur Herstellung eines solchen Gehäuses, ein elektrisches Gerät mit einem solchen Gehäuse und eine Verwendung eines solchen Gehäuses für ein elektrisches Gerät, wobei bei dem Gehäuse mindestens eine Oberfläche zur Verringerung des Diffusionskoeffizienten metallisiert ist.

## Patentansprüche

1. Gehäuse für ein elektrisches Gerät, **dadurch gekennzeichnet, dass** das Gehäuse auf einer Außen- oder Innenoberfläche metallisiert ist.

2. Gehäuse nach Anspruch 1, wobei sowohl die Außenoberfläche wie auch die Innenoberfläche metallisiert ist.

3. Verfahren zur Herstellung eines Gehäuses für ein elektrisches Gerät, wobei ein Gehäusegrundkörper (10) auf einer Außen- oder Innenoberfläche metallisiert wird.

4. Verfahren nach Anspruch 3, wobei der Gehäusegrundkörper (10) auf einer Außen- und Innenoberfläche metallisiert wird.

5. Verfahren nach Anspruch 3 oder 4, wobei das Metallisieren berührungslos erfolgt.

6. Verfahren nach Anspruch 3, 4 oder 5, wobei zum Metallisieren einer Außen- oder Innenoberfläche des Gehäusegrundkörpers (10) ein Verfahren der physikalischen Gasphasenabscheidung verwendet wird.

7. Elektrisches Gerät, insbesondere Automatisierungsgerät, mit einem Gehäuse nach einem der Ansprüche 1 oder 2 oder mit einem nach einem Verfahren der Ansprüche 3 bis 6 hergestellten Gehäuse (10).

8. Verwendung eines Gehäuses nach einem der Ansprüche 1 oder 2 oder eines nach einem Verfahren der Ansprüche 3 bis 6 hergestellten Gehäuses als Gehäuse mit einem verminderten Diffusionskoeffizienten für ein elektrisches Gerät, insbesondere ein Automatisierungsgerät.
